# EUROPÄISCHE PATENTSCHRIFT

(11) **EP 2 000 914 B1**
(45) Veröffentlichungstag und Bekanntmachung des Hinweises auf die Patenterteilung: **04.04.2012**
(21) Anmeldenummer: 08104224.4
(22) Anmeldetag: 02.06.2008
(51) Int. Cl.: G06F 12/02, G11C 16/10

(54) **Verfahren und Vorrichtung zum Umorganisieren von Daten in einem Speichersystem, insbesondere für Steuergeräte in Kraftfahrzeugen**
Method and device for reorganising data in a storage system, in particular for control devices in motor vehicles
Procédé et dispositif destinés à réorganiser les données dans un système de stockage, en particulier pour appareils de commande dans des véhicules automobiles

(30) Priorität: 08.06.2007 DE 102007026693
(43) Veröffentlichungstag der Anmeldung: 10.12.2008
(73) Patentinhaber: Robert Bosch GmbH, 70442 Stuttgart (DE)
(72) Erfinder: Boettcher, Joern, 74232 Abstatt (DE); Liebehenschel, Jens, 65835 Liederbach (DE); Schmid, Markus, 70182 Stuttgart (DE)

(56) Entgegenhaltungen:
- EP-A- 1 031 929
- WO-A-02/50844
- DE-A1- 19 506 957
- US-A1- 2006 155 917

## Beschreibung

### Technisches Gebiet

Die Erfindung betrifft ein Verfahren und eine Vorrichtung zum Umorganisieren von Daten in einem nicht-flüchtigen Speicher eines Speichersystems, insbesondere in Steuergeräten in Kraftfahrzeugen.

### Stand der Technik

Steuergeräte für den Automotiv-Bereich werden üblicherweise zur Steuerung und Überwachung von Funktionen des Fahrzeugmotors und/oder weiterer elektrischer Systeme im Kraftfahrzeug eingesetzt. Ein derartiges Steuergerät ist vorzugsweise mit einem nicht-flüchtigen Speicher ausgestattet, um verschiedene Betriebsgrößen und dgl. permanent, d.h. auch bei nicht anliegender Versorgungsspannung zu speichern, so dass das Steuergerät z.B. auch auf zurückliegende Daten zurückgreifen kann.

Die Anforderung an die im Automotiv-Bereich eingesetzten Komponenten sind jedoch sehr hoch, und es wird im allgemeinen eine sehr hohe Zuverlässigkeit während der gesamten Lebensdauer des Kraftfahrzeugs gefordert. An die in Automotiv-Steuergeräten eingesetzten nichtflüchtigen Speicher werden daher ebenfalls hohe Anforderungen gestellt. Üblicherweise werden als nichtflüchtige Speicher für Automotiv-Steuergeräte Flash-Speicher eingesetzt. Aufgrund von Degradationseffekten der Flash-Speicherzellen ist die Lebensdauer einer Flash-Speicherzelle auf eine bestimmte Anzahl von Schreibzyklen beschränkt. Herstellerseitig wird üblicherweise für einen Flash-Speicher eine bestimmte Anzahl von Schreibzyklen für eine bestimmte Gesamt-Betriebsdauer des Kraftfahrzeugs, während der das betreffende Steuergerät betrieben wird, gewährleistet.

Um die Häuflgkeit, mit der in einem Steuergerät eine bestimmte Speicherzelle des nicht-flüchtigen Speichers überschrieben wird, zu reduzieren, wird die Größe des Speichers im Steuergerät erhöht und darin abzuspeichernde Betriebsgrößen in den Speicherbereich aufeinander folgend geschrieben. Ist ein Speicherbereich des Speichers , d.h. ein Segment, mit Betriebsgrößendaten gefüllt, so werden die jeweils aktuellsten Betriebsgrößendaten jeden Typs in einem Umorganisationsprozess in ein weiteres Segment kopiert und das vollständig beschriebene Segment in einer Löschoperation sofort oder vor einem erneuten Beschreiben gelöscht.

Bislang werden bei der Umorganisation der Daten die jeweils aktuellsten Betriebsgrößendaten des vollständig bzw. nahezu vollständig beschriebenen Segmentes gesucht und Byte-weise in das entsprechend weitere Segment, das in Folge mit Betriebsgrößendaten beschrieben werden soll, geschrieben. Weiterhin können Betriebsgrößendaten aus einem Arbeitsspeicher des Steuergeräts, d.h. einem Schreib-/Lesespeicher, der Daten in der Regel flüchtig speichert, wie z.B. einem RAM, beim Umorganisieren der Daten, d.h. z.B. einem Umordnen der Daten, in das weitere Segment geschrieben werden, wobei diese Daten aus dem Arbeitsspeicher ebenfalls Byte-weise in das weitere Segment geschrieben werden. Dadurch, dass für das Schreiben jedes Bytes eine einzelne Zugriffsoperation auf den nicht-flüchtigen Speicher benötigt, ist die Umorganisation der Daten in einem derartigen Speichersystem aufwendig.

In der Druckschrift EP 1 031 929 A1 ist ein Verfahren zum Umorganisieren von Betriebsgrößendaten in ein Segment des nicht flüchtigen Speichers beschrieben. Dabei werden bei einer Initialisierung des Systems die jeweils aktuellsten Betriebsgrößendaten aus einem Segment des nicht-flüchtigen Speichers ausgelesen und in einen Adressbereich eines Firmware-Speichers gespeichert. Wenn das Segment des nicht flüchtigen Speichers keinen Speicherplatz mehr aufweist, können die Betriebsgrößendaten, die in dem Firmware-Speicher gespeichert sind, in ein nicht verwendetes Segment des nicht flüchtigen Speichers geschrieben werden.

Die Druckschrift US 2006/155917 A1 offenbart ein Verfahren zum Steuern von Schreib und Leseoperationen in einer Speichervorrichtung mit Speicherblöcken, die aufgrund von wiederholten Löschungsverfahren einer Abnutzung unterliegen. Dabei wird versucht, die Löschungsvorgänge in dem Speicher möglichst gleich zu verteilen.

Die Druckschrift DE 19506957 A1 offenbart ein Verfahren und eine Anordnung zum Aktualisieren und Laden von Anwenderprogrammen in einem Programmspeicher eines Mikroprozessorsystems.

Die Druckschrift WO 02/50844 A offenbart eine Vorrichtung zum Sichern von Datenbereichen eines Speichers in einem elektronischen Baustein, wobei Daten zwischen einem EPROM- und einem RAM-Speicher kopiert werden.

### Offenbarung der Erfindung

Es ist Aufgabe der vorliegenden Erfindung, ein Verfahren und eine Vorrichtung zur Verfügung zu stellen, womit das Umorganisieren der Daten in einem Speichersystem für ein Steuergerät effizienter durchgeführt werden kann.

Diese Aufgabe wird durch das Verfahren gemäß Anspruch 1 sowie durch das Steuergerät gemäß dem nebengeordneten Anspruch 6 gelöst.

Weitere vorteilhafte Ausgestaltungen der Erfindung sind in den abhängigen Ansprüchen angegeben.

### Kurzbeschreibung der Zeichnungen

Bevorzugte Ausführungsformen werden nachfolgend anhand der beigefügten Zeichnungen näher erläutert. Es zeigen:
- Fig. 1: eine schematische Darstellung eines Steuergeräts gemäß einer Ausführungsform der Erfindung; und
- Fig. 2: eine schematische Darstellung des Verfahrens zum Umorganisieren von Daten gemäß einer weiteren Ausführungsform der Erfindung.

### Beschreibung der bevorzugten Ausführungsformen

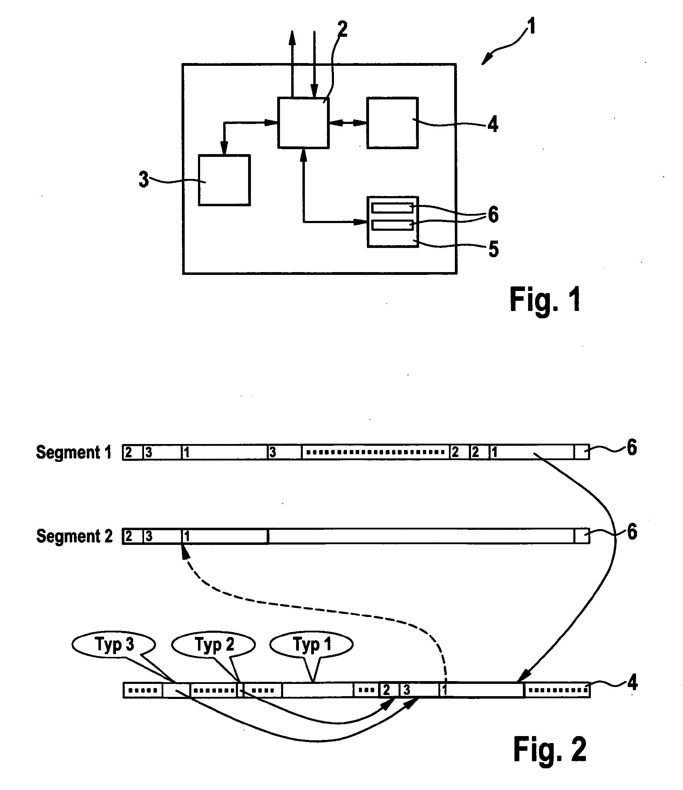

In Fig. 1 ist ein Steuergerät 1 z.B. für den Einsatz im Automotiv-Bereich dargestellt. Das Steuergerät 1 weist eine Steuereinheit 2 auf. Die Steuereinheit 2 führt Verfahren und Berechnungen durch, um eine Steuerung von Fahrzeugsystemen, wie z.B. die Motorsteuerung, die Steuerung weiterer elektrischer Systeme im Kraftfahrzeug und dgl. durchzuführen. Die Steuereinheit 2 ist mit einem Programm- und Festdatenspeicher 3 gekoppelt, in dem Programmbefehle zum Durchführen des von der Steuereinheit 2 ausgeführten Steuerverfahrens sowie unveränderliche Festdaten, wie z.B. Konstanten, Kennfelder und dergleichen gespeichert sind. Der Festdatenspeicher 3 ist vorzugsweise als nichtflüchtiger, durch die Steuereinheit 2 im Normalbetrieb nicht beschreibbarer Speicher, wie z.B. ein ROM, Flash-Speicher, EPROM, EEPROM und dgl. ausgeführt.

Weiterhin ist die Steuereinheit 2 mit einem Arbeitsspeicher 4 in Form eines Schreib-/Lesespeichers gekoppelt, wie z.B. einem RAM, d.h. einem wahlweise beschreibbaren Speicher. Der Arbeitsspeicher 4 wird für die Ausführung der in dem Festwertspeicher 3 vorgegebenen Instruktionen benötigt. Der Arbeitsspeicher 4 kann als flüchtiger Speicher vorgesehen sein, wie z.B. in Form eines SRAM (Statisches RAM) oder DRAM (Dynamischer Speicher).

Bei der Steuerung von Systemen durch die Steuereinheit 2 ist es häufig notwendig, Informationen über die zu steuernden Systeme, über Umfeldbedingungen und dergleichen als Betriebsgrößendaten zu erfassen, zu ermitteln und zu aktualisieren und die jeweils aktuellsten Betriebsgrößendaten permanent verfügbar zu halten, auch über einen Zeitraum hinweg, während dem das Steuergerät 1 für eine bestimmte Zeit ausgeschaltet ist, d.h. nicht mit einer Versorgungsspannung versorgt wird. Daten, die in dem Arbeitsspeicher 4 gespeichert sind, gehen während einer solchen Zeitdauer verloren.

Zum Speichern derartiger Betriebsgrößendaten ist daher ein von der Steuereinheit 2 beschreibbarer nicht-flüchtiger Speicher 5, z.B. in Form eines Flash-Speichers, vorgesehen. Der nicht-flüchtige Speicher 5 weist dazu zwei oder mehr als zwei Segmente 6, d.h. physikalische voneinander getrennte Speicherabschnitte, auf, die wechselweise mit Betriebsgrößendaten beschrieben werden. Im Detail werden zu speichernde Betriebsgrößendaten aufeinander folgend, d.h. der Reihe nach, in den Adressbereich eines ersten Segments 6 geschrieben. Wenn dieses erste Segment 6 vollständig bzw. nahezu vollständig beschrieben worden ist, so dass weitere Betriebsgrößendaten nicht mehr vollständig darin gespeichert werden können, werden die nachfolgenden zu speichernden Betriebsgrößendaten in einem zweiten der Segmente 6 geschrieben.

Damit beim Wechsel der Segmente 6 des nicht-flüchtigen Speichers 5 zu jedem Zeitpunkt aktuelle Betriebsgrößendaten gespeichert bleiben, werden die jeweils aktuellsten Betriebsgrößendaten aus dem ersten Segment 6 und/oder aus dem Arbeitsspeicher 4 ermittelt und an den Beginn des Adressbereichs des zweiten Segmentes 6 des nicht-flüchtigen Speichers 5 geschrieben, bevor das erste Segment 6 gelöscht oder zum Überschreiben freigegeben wird. Dazu werden die aktuellsten Betriebsgrößendaten jeden Typs (entsprechend des verkörpernden Parameters) ermittelt und vorab in das zweite Segment geschrieben. Die Betriebsgrößendaten können in einer bestimmten Reihenfolge oder in nicht zuvor bestimmter Reihenfolge ungeordnet in das betreffende zweite Segment 6 hineingeschrieben werden. Ein solcher Schreibvorgang erfolgt bislang Byte-weise oder Wort-weise (oder in anderen Datenblöcken mit geringer Bitanzahl =< 32) und erfordert eine größere Anzahl von Schreibzugriffen auf den nichtflüchtigen Speicher 5. Dies stellt eine erhöhte Verarbeitungslast für die Steuereinheit 2 dar.

Häufig ist ein nichtflüchtiger Speicher 5, wie er in Steuergeräten 1 vorgesehen ist, in der Lage, in einer weiteren Betriebsart einen so genannten Blockschreibprozess durchzuführen, bei dem mehr als ein Byte gleichzeitig aus dem Arbeitsspeicher 4 in einen Adressbereich des nicht-flüchtigen Speichers 5 geschrieben werden kann. Voraussetzung hierfür ist eine bestimmte Konstellation der Daten in dem Arbeitsspeicher 4, insbesondere müssen die entsprechenden Daten aufeinander folgend als Datenblock vorliegen. Es ist nun vorgesehen, diese Betriebsart zu nutzen und die anfänglich in ein neues Segment 6 des nicht-flüchtigen Speicher zu schreibenden Betriebsgrößendaten zunächst in dem Arbeitsspeicher 4 in einem Datenblock zusammenzustellen und anschließend den zusammengestellten Datenblock in das zur nachfolgenden Speicherung von Betriebsgrößendaten vorgesehene Segment 6 des nichtflüchtigen Speichers 5 zu schreiben.

Im Idealfall können die relevanten Betriebsgrößendaten vollständig aus dem gefüllten Segment 6 des nichtflüchtigen Speichers 5 ausgelesen und in das RAM in einen zusammenhängenden Adressbereich geschrieben werden. Entsprechend der verschiedenen als Betriebsgrößendaten zu speichernden Parameter werden die Typen der Betriebsgrößendaten in der Darstellung der Fig. 2 als Typ 1, Typ 2 und Typ 3 bezeichnet. Gemäß einer Ausführungsform wird für jeden Typ von Betriebsgrößendaten das Datum mit dem aktuellsten Wert aus dem gefüllten Segment 6 des nichtflüchtigen Speichers 5 ausgewählt und in den Arbeitsspeicher 4 kopiert. Wird für ein Betriebsgrößendatum eines bestimmten Typs festgestellt, dass der in dem gefüllten Segment 6 gespeicherten Wert nicht dem aktuellsten Wert entspricht bzw. dieser sich nicht in einem zu den übrigen Betriebsgrößendaten konsistenten Zustand befindet, kann das in das zweite Segment 6 zu speichernde Betriebsgrößendatum des entsprechenden Typs auch von einer anderen Position in den Arbeitsspeicher 4 kopiert werden, z.B. von einer anderen Speicherposition des Arbeitsspeichers 4 bzw. von extern. Auf diese Weise kann ein Datenblock aus Betriebsgrößendaten aus dem ersten Segment 6 und/oder aus Speicherpositionen des Arbeitsspeichers 4 in einen zuvor ausgewählten Adressbereich des Arbeitsspeichers 4 kopiert werden, um anschließend den entsprechenden Datenblock in einem Blockschreibeprozess in das zweite Segment 6 zu schreiben.

Im gezeigten Ausführungsbeispiel der Fig. 2 werden die Betriebsgrößendaten des Typs 1 aus dem vollständig beschriebenen Segment des nicht-flüchtigen Speichers 5 und die Betriebsgrößendaten der Typen 2 und 3 aus dem Arbeitsspeicher 4 in den Adressbereich (fett umrandet) kopiert, der mit dem Blockschreibprozess in das neu zu beschreibende Segment des nichtflüchtigen Speichers 5 kopiert werden soll.

Bei einer weiteren Ausführungsform werden in o. a. Weise die Betriebsgrößendaten in das betreffende Segment 6 in einen bestimmten Adressbereich und eine entsprechende Verweisungsinformation in einem Verweisungsabschnitt an einen weiteren Adressbereich des Segments des nichtflüchtigen Speichers 5 geschrieben. Die Verweisungsinformation gibt dann entsprechend den Typ und die Position, d.h. die Adresse, an, an dem sich die Betriebsgrößendaten des bestimmten durch die Verweisungsinformation referenzierten Typs befinden. Beim Umorganisieren der Betriebsgrößendaten beim Wechseln von dem ersten auf das zweite Segment 6 des nicht-flüchtigen Speichers 5 ist es dann notwendig, in das neu zu beschreibende Segment 6 des nichtflüchtigen Speichers 5 sowohl den Datenblock der zusammengestellten Betriebsgrößendaten als auch einen weiteren Datenblock mit den dazugehörigen Verweisungsinformationen zu schreiben.

Unter Umständen ist es nicht erforderlich, die Daten im Arbeitsspeicher 4 in einem separaten Bereich als Datenblock aufzubereiten. Es ist möglich, durch die Operation der Steuereinheit 2, dass die Betriebsgrößendaten im Arbeitsspeicher 4 so angeordnet sind, dass die Betriebsgrößendaten als Datenblock direkt auf das neu zu beschreibende Segment 6 des nichtflüchtigen Speichers 5 übertragen werden können. Die Voraussetzungen hierfür sind, dass die Daten zu bestimmten Zeitpunkten konsistent sind und dass die Repräsentation der Betriebsgrößendaten im Arbeitspeicher 4 der Repräsentation der Betriebsgrößendaten im nichtflüchtigen Speicher 5 entspricht. Dies wäre beispielsweise nicht der Fall, wenn Daten in dem nichtflüchtigen Speicher z.B. verschlüsselt abgelegt würden.

Das Verfahren der vorliegenden Erfindung ist insbesondere vorteilhaft, wenn der nicht-flüchtige Speicher eine kleine Dateneinheit (z.B. ein Byte) mit der gleichen Geschwindigkeit schreibt wie einen großen zusammenhängenden Datenblock (mehrere Bytes), sodass durch die Verwendung des Blockschreibprozesses die Anzahl der Zyklen zum Schreiben der Betriebsgrößendaten beim Umorganisieren der Betriebsgrößendaten auf ein Segment deutlich reduziert werden kann. Dieser Geschwindigkeitszuwachs kann zu einer Vereinfachung der Software und einer Erhöhung der Zuverlässigkeit des Steuergeräts führen.

Besonders vorteilhaft ist es, wenn die Betriebsgrößendaten insgesamt aus dem Arbeitsspeicher 4 direkt verwendet werden können, so dass der zu schreibende Datenblock nicht über langsame Zugriffe auf das vollständig beschriebene Segment 6 des nichtflüchtigen Speichers 5 gesucht werden muss. Dies ist im Bereich eingebetteter Systeme wichtig, da zu jedem Zeitpunkt mit einem Spannungseinbruch zu rechnen ist. Ein Spannungseinbruch führt zu Datenverlust im Arbeitsspeicher 4, falls sich die Daten nur im Arbeitsspeicher 4 befinden.

Das Verfahren zum Umorganisieren von Betriebsgrößendaten wird vorzugsweise durch die Steuereinheit 2 ausgeführt. Das Verfahren kann darin durch eine Hardware-Implementierung, einer Implementierung mit Hilfe einer Software, die einem Computerprogramm entspricht, sowie durch eine Implementierung durch Hardware und Software realisiert werden.

## Patentansprüche

1. Verfahren zum Umorganisieren von Betriebsgrößendaten zwischen Segmenten eines nicht-flüchtigen Speichers (5), wobei die Betriebsgrößendaten verschiedenen Typen von Betriebsgrößendaten umfassen, mit folgenden Schritten:
- Aufeinander folgendes Schreiben der zu schreibenden Betriebsgrößendaten in einen Adressbereich eines ersten Segments (6), wobei das Schreiben gemäß einer Betriebsart in mehreren Schreibzugriffen byte- oder wortweise erfolgt;
- wenn kein Speicherplatz zum Schreiben von zu schreibenden Betriebsgrößendaten
- in dem ersten Segment (6) vorhanden ist, Durchführen folgender Schritte:
- Erzeugen eines zusammenhängenden Datenblockes an einem Adressbereich eines von dem nicht-flüchtigen Speicher separaten Arbeitsspeichers (4) aus den aktuellsten Betriebsgrößendaten jeden Typs aus dem ersten Segment (6) des nicht-flüchtigen Speichers (5) und/oder aus dem Arbeitsspeicher;
- Erzeugen eines weiteren zusammenhängenden Datenblocks an einem weiteren Adressbereich des Arbeitsspeichers (4), wobei der weitere Datenblock Verweisungsdaten aufweist, die für jeden Typ von Betriebsgrößendaten auf die in das erste oder zweite Segment (6) zu schreibende Betriebsgrößendaten verweisen,
- Kopieren des Datenblockes in einem Blockschreibeprozess in einen vordefinierten Adressbereich eines zweiten Segmentes (6) des nicht-flüchtigen Speichers (5), wobei der Blockschreibeprozess einer weiteren Betriebsart entspricht, bei der die Betriebsgrößendaten des zusammenhängenden Datenblockes im Arbeitsspeicher (4) gleichzeitig in den vordefinierten Adressbereich geschrieben werden, wobei der weitere Datenblock in einem weiteren Blockschreibeprozess in einen vordefinierten weiteren Adressbereich des ersten bzw. zweiten Segmentes (6) des nicht-flüchtigen Speichers (5) kopiert wird.

2. Verfahren nach Anspruch 1, wobei beim Erzeugen des Datenblockes eine Konsistenzprüfung durchgeführt wird, um verschiedene Betriebsgrößendaten abhängig von dem Ergebnis der Konsistenzprüfung aus dem ersten Segment (6) des nicht-flüchtigen Speichers (5) und dem Arbeitsspeicher (4) so zusammenzustellen, dass die Zusammenstellung der Betriebsgrößendaten konsistent ist.

3. Verfahren nach Anspruch 1 oder 2, wobei nach dem Blockschreibeprozess das erste Segment (6) des nicht-flüchtigen Speichers (5) gelöscht oder zum Überschreiben freigegeben wird.

4. Verfahren nach Anspruch 1 oder 2, wobei vor dem Blockschreibeprozess das zweite Segment (6) des nicht-flüchtigen Speichers (5) gelöscht oder zum Überschreiben freigegeben wird.

5. Verfahren nach einem der Ansprüche 1 bis 4, wobei die Betriebsgrößendaten aufeinander folgend und sich aneinander anschließend in das zu beschreibende Segment (6) des nicht-flüchtigen Speichers (5) geschrieben werden.

6. Steuergerät (1) zum Umorganisieren von Betriebsgrößendaten zwischen Segmenten in einem nicht-flüchtigen Speicher (5), insbesondere für automotive Anwendungen, wobei die Betriebsgrößendaten verschiedenen Typen von Betriebsgrößendaten umfassen, wobei das Steuergerät (1)
- eine Steuereinheit (2);
- einen nicht-flüchtigen Speicher (5) zum nicht-flüchtigen Speichern von Betriebsgrößendaten;
- einen Arbeitsspeicher zum Beschreiben und Auslesen von Daten durch die Steuereinheit (2)
umfasst, **dadurch gekennzeichnet, dass** die Steuereinheit (2) in der Art ausgebildet ist, um die zu schreibenden Betriebsgrößendaten in einen Adressbereich eines ersten Segments (6) aufeinander folgend zu schreiben, wobei das Schreiben gemäß einer Betriebsart in mehreren Schreibzugriffen byte- oder wortweise erfolgt; und um, wenn kein Speicherplatz zum Schreiben von zu schreibenden Betriebsgrößendaten in dem ersten Segment (6) vorhanden ist, einen zusammenhängenden Datenblock an einem Adressbereich eines Arbeitsspeichers (4) aus den aktuellsten Betriebsgrößendaten jeden Typs aus einem ersten Segment (6) des nicht-flüchtigen Speichers (5) und/oder aus dem Arbeitsspeicher (4) zu erzeugen und um einen weiteren zusammenhängenden Datenblock an einem weiteren Adressbereich des Arbeitsspeichers (4) zu erzeugen, wobei der weitere Datenblock Verweisungsdaten aufweist, die für jeden Typ von Betriebsgrößendaten auf die in das erste oder zweite Segment (6) zu schreibende Betriebsgrößendaten verweisen, den Datenblock in einem Blockschreibeprozess in einen vordefinierten Adressbereich des zweiten Segmentes (6) des nicht-flüchtigen Speichers (5) zu kopieren, wobei der Blockschreibeprozess einer weiteren Betriebsart entspricht, bei der die Betriebsgrößendaten des zusammenhängenden Datenblockes im Arbeitsspeicher (4) gleichzeitig in den vordefinierten Adressbereich geschrieben werden, wobei der weitere Datenblock in einem weiteren Blockschreibeprozess in einen vordefinierten weiteren Adressbereich des ersten bzw. zweiten Segmentes (6) des nicht-flüchtigen Speichers (5) kopiert wird.

7. Steuergerät (1) nach Anspruch 6 wobei der nicht-flüchtige Speicher (5) einen Flash-Speicher umfasst.

8. Steuergerät nach Anspruch 6 oder 7, wobei die Steuereinheit (2) ausgebildet ist, eine Konsistenzprüfung durchzuführen, um beim Erzeugen des zusammenhängenden Datenblockes verschiedene Betriebsgrößendaten abhängig von dem Ergebnis der Konsistenzprüfung aus dem ersten Segment (6) des nicht-flüchtigen Speichers (5) und dem Arbeitsspeicher (4) so zusammenzustellen, dass die Zusammenstellung der Betriebsgrößendaten konsistent ist.

9. Computerprogramm mit einem maschinenlesbaren Code, das, wenn es auf einer Steuereinheit ausgeführt wird, ein Verfahren gemäß einem der Ansprüche 1 bis 5 ausführt.

## Claims

1. Method for reorganizing parameters between segments of a nonvolatile memory (5), wherein the parameters comprise different types of performance quantity data, comprising the following steps:
- the parameters that are to be written are successively written to an address range of a first segment (6), wherein the writing takes place on a byte-by-byte or word-by-word basis in a plurality of write access operations in one mode of operation;
- if no memory space for writing parameters that are to be written
- is available in the first segment (6), the following steps are performed:
- a contiguous data block is generated on an address range of a main memory (4), which is separate from the nonvolatile memory (5), from the most up-to-date parameters of each type from the first segment (6) of the nonvolatile memory (5) and/or from the main memory;
- a further contiguous data block is generated on a further address range of the main memory (4), wherein the further data block has reference data which, for each type of performance quantity data, refer to the parameters that are to be written to the first or second segment (6),
- the data block is copied to a predefined address range of the second segment (6) of the nonvolatile memory (5) in a block writing process, wherein the block writing process corresponds to a further mode of operation in which the parameters from the contiguous data block in the main memory (4) are simultaneously written to the predefined address range, wherein the further data block is copied to a predefined further address range of the first or second segment (6) of the nonvolatile memory (5) in a further block writing process.

2. Method according to Claim 1, wherein the generation of the data block involves the performance of a consistency check in order to compile different parameters from the first segment (6) of the nonvolatile memory (5) and from the main memory (4) on the basis of the result of the consistency check such that the compilation of the parameters is consistent.

3. Method according to Claim 1 or 2, wherein the block writing process is followed by the first segment (6) of the nonvolatile memory (5) being erased or being released for overwriting.

4. Method according to Claim 1 or 2, wherein the block writing process is preceded by the second segment (6) of the nonvolatile memory (5) being erased or being released for overwriting.

5. Method according to one of Claims 1 to 4, wherein the parameters are written to the segment (6) of the nonvolatile memory (5) that is to have data written to it consecutively and successively.

6. Controller (1) for reorganizing parameters between segments in a nonvolatile memory (5), particularly for automotive applications, wherein the parameters comprise different types of performance quantity data, wherein the controller (1) comprises
- a control unit (2);
- a nonvolatile memory (5) for the nonvolatile storage of performance quantity data;
- a main memory for the control unit (2) to write and read data,
**characterized in that** the control unit (2) is designed to successively write the parameters that are to be written to an address range of a first segment (6), wherein the writing takes place on a byte-by-byte or word-by-word basis in a plurality of write access operations in one mode of operation; and, if no memory space for writing parameters that are to be written is available in the first segment (6), to produce a contiguous data block on an address range of a main memory (4) from the most up-to-date parameters of each type from the first segment (6) of the nonvolatile memory (5) and/or from the main memory (4) and to produce a further contiguous data block on a further address range of the main memory (4), wherein the further data block has reference data which, for each type of performance quantity data, refer to the parameters that are to be written to the first or second segment (6), to copy the data block to a predefined address range of the second segment (6) of the nonvolatile memory (5) in a block writing process, wherein the block writing process corresponds to a further mode of operation in which the parameters from the contiguous data block in the main memory (4) are simultaneously written to the predefined address range, wherein the further data block is copied to a predefined further address range of the first or second segment (6) of the nonvolatile memory (5) in a further block writing process.

7. Controller (1) according to Claim 6, wherein the nonvolatile memory (5) comprises a flash memory.

8. Controller according to Claim 6 or 7, wherein the control unit (2) is designed to perform a consistency check in order to compile, during the generation of the contiguous data block, different parameters from the first segment (6) of the nonvolatile memory (5) and from the main memory (4) on the basis of the result of the consistency check such that the compilation of the parameters is consistent.

9. Computer program having a machine-readable code which, when executed on a control unit, performs a method according to one of Claims 1 to 5.

## Revendications

1. Procédé pour réorganiser des données de grandeurs opérationnelles entre les segments d'une mémoire non volatile (5), les données de grandeurs opérationnelles englobant différents types de données de grandeurs opérationnelles, comprenant les étapes suivantes :
- écriture successive des données de grandeurs opérationnelles à écrire dans une plage d'adresses d'un premier segment (6), l'écriture s'effectuant octet par octet ou mot par mot en plusieurs accès en écriture, conformément à un mode de fonctionnement ;
- lorsqu'il n'existe pas d'espace mémoire pour écrire des données de grandeurs opérationnelles à écrire dans le premier segment (6), exécution des étapes suivantes :
- génération d'un bloc de données continu au niveau d'une plage d'adresses d'une mémoire de travail (4) séparée de la mémoire non volatile à partir des données de grandeurs opérationnelles les plus récentes de chaque type issues du premier segment (6) de la mémoire non volatile (5) et/ou de la mémoire de travail ;
- génération d'un autre bloc de données continu au niveau d'une autre plage d'adresses de la mémoire de travail (4), l'autre bloc de données présentant des données de renvoi qui, pour chaque type de données de grandeurs opérationnelles, renvoient aux données de grandeurs opérationnelles à écrire dans le premier ou le deuxième segment (6) ;
- copie du bloc de données dans un processus d'écriture de bloc dans une plage d'adresses prédéfinie du deuxième segment (6) de la mémoire non volatile (5), le processus d'écriture de bloc correspondant à un autre mode de fonctionnement dans lequel les données de grandeurs opérationnelles du bloc de données continu dans la mémoire de travail (4) sont écrites simultanément dans la plage d'adresses prédéfinie, l'autre bloc de données étant copié au cours d'un autre processus d'écriture de bloc dans une autre plage d'adresses prédéfinie du premier ou du deuxième segment (6) de la mémoire non volatile (5).

2. Procédé selon la revendication 1, selon lequel, lors de la génération du bloc de données, un contrôle de cohérence est effectué afin de regrouper différentes données de grandeurs opérationnelles issues du premier segment (6) de la mémoire non volatile (5) et de la mémoire de travail (4) en fonction du résultat du contrôle de cohérence de telle sorte que le regroupement des données de grandeurs opérationnelles est cohérent.

3. Procédé selon la revendication 1 ou 2, selon lequel, après le processus d'écriture de bloc, le premier segment (6) de la mémoire non volatile (5) est effacé ou libéré pour être réécrit.

4. Procédé selon la revendication 1 ou 2, selon lequel, avant le processus d'écriture de bloc, le deuxième segment (6) de la mémoire non volatile (5) est effacé ou libéré pour être réécrit.

5. Procédé selon l'une des revendications 1 à 4, selon lequel les données de grandeurs opérationnelles sont écrites dans le segment (6) à écrire de la mémoire non volatile (5) en se suivant et en étant rattachées les unes aux autres.

6. Contrôleur (1) pour réorganiser des données de grandeurs opérationnelles entre les segments d'une mémoire non volatile (5), notamment pour des applications en automobile, les données de grandeurs opérationnelles englobant différents types de données de grandeurs opérationnelles, le contrôleur (1) comprenant :
- une unité de commande (2) ;
- une mémoire non volatile (5) pour l'enregistrement non volatil de données de grandeurs opérationnelles ;
- une mémoire de travail pour l'écriture et la lecture de données par l'unité de commande (2), **caractérisé en ce que** l'unité de commande (2) est configurée pour écrire successivement les données de grandeurs opérationnelles à écrire dans une plage d'adresses d'un premier segment (6), l'écriture s'effectuant octet par octet ou mot par mot en plusieurs accès en écriture, conformément à un mode de fonctionnement ;
et pour, lorsqu'il n'existe pas d'espace mémoire pour écrire des données de grandeurs opérationnelles à écrire dans le premier segment (6), générer un bloc de données continu au niveau d'une plage d'adresses d'une mémoire de travail (4) à partir des données de grandeurs opérationnelles les plus récentes de chaque type issues du premier segment (6) de la mémoire non volatile (5) et/ou de la mémoire de travail (4) et
pour générer un autre bloc de données continu au niveau d'une autre plage d'adresses de la mémoire de travail (4), l'autre bloc de données présentant des données de renvoi qui, pour chaque type de données de grandeurs opérationnelles, renvoient aux données de grandeurs opérationnelles à écrire dans le premier ou le deuxième segment (6), et
copier le bloc de données dans un processus d'écriture de bloc dans une plage d'adresses prédéfinie d'un deuxième segment (6) de la mémoire non volatile (5), le processus d'écriture de bloc correspondant à un autre mode de fonctionnement dans lequel les données de grandeurs opérationnelles du bloc de données continu dans la mémoire de travail (4) sont écrites simultanément dans la plage d'adresses prédéfinie, l'autre bloc de données étant copié au cours d'un autre processus d'écriture de bloc dans une autre plage d'adresses prédéfinie du premier ou du deuxième segment (6) de la mémoire non volatile (5).

7. Contrôleur (1) selon la revendication 6, dans lequel la mémoire non volatile (5) comprend une mémoire flash.

8. Contrôleur selon la revendication 6 ou 7, dans lequel l'unité de commande (2) est configurée pour effectuer un contrôle de cohérence afin de regrouper, lors de la génération du bloc de données continu, les différentes données de grandeurs opérationnelles issues du premier segment (6) de la mémoire non volatile (5) et de la mémoire de travail (4) en fonction du résultat du contrôle de cohérence de telle sorte que le regroupement des données de grandeurs opérationnelles est cohérent.

9. Programme informatique muni d'un code lisible par machine qui, lorsqu'il est exécuté sur une unité de commande, met en oeuvre un procédé selon l'une des revendications 1 à 5.
